# EUROPÄISCHE PATENTSCHRIFT

(11) **EP 2 002 446 B1**
(45) Veröffentlichungstag und Bekanntmachung des Hinweises auf die Patenterteilung: **18.01.2012**
(21) Anmeldenummer: 07726875.3
(22) Anmeldetag: 14.03.2007
(51) Int. Cl.: G11C 29/00, G06F 11/10

(54) **VERFAHREN ZUM BETREIBEN EINER SPEICHEREINRICHTUNG MIT MARKIERUNG VON ALS FEHLERHAFT ERKANNTEN SPEICHERBLÖCKEN**
METHOD FOR OPERATING A MEMORY UNIT COMPRISING THE MARKING OF MEMORY BLOCKS THAT ARE IDENTIFIED AS DEFECTIVE
PROCÉDÉ POUR FAIRE FONCTIONNER UN DISPOSITIF DE MÉMOIRE COMPRENANT LE MARQUAGE DE BLOCS DE MÉMOIRE IDENTIFIÉES COMME DÉFECTUEUX

(30) Priorität: 24.03.2006 DE 102006013758
(43) Veröffentlichungstag der Anmeldung: 17.12.2008
(73) Patentinhaber: Robert Bosch GmbH, 70442 Stuttgart (DE)
(72) Erfinder: LIEBEHENSCHEL, Jens, 65835 Liederbach (DE); BOETTCHER, Joern, 71229 Leonberg (DE)
(86) Internationale Anmeldenummer: PCT/EP2007/052379
(87) Internationale Veröffentlichungsnummer: WO 2007/110325

(56) Entgegenhaltungen:
- US-A- 5 475 693
- US-A- 6 058 047
- US-B2- 6 751 123

## Beschreibung

Die Erfindung betrifft ein Verfahren zum Betreiben einer Speichereinrichtung, eine Vorrichtung zum Betreiben einer Speichereinrichtung, eine Speichereinrichtung, ein Computerprogramm und ein Computerprogrammprodukt.

### Stand der Technik

Bei einer Speicherung nichtflüchtiger Daten auf Medien, wie bspw. einer EEPROM-Speicher-Hardware, oder bei bestimmten Klassen von blockorientierten EEPROM-Dateisystemen gibt es keine feste Zuordnung von Daten und Speicherbereichen auf dem Medium. Die Daten werden immer wieder an unterschiedlichen Positionen abgespeichert. Es ist somit erforderlich, vor dem Schreiben von Daten nach leeren Blöcken zu suchen. Bei der Suche nach freien Blöcken sollten keine defekten Blöcke ausgewählt werden, außerdem sollte immer eine möglichst große Anzahl an freien Blöcken zur Verfügung stehen.

Aufgrund von Fehlern in derartiger Speicher-Hardware oder wegen nicht abgeschlossener Schreibvorgänge aufgrund von Spannungsunterbrechungen oder Resets können Blöcke aus Sicht der Software fehlerhaft erscheinen. Im allgemeinen kann durch das Lesen der Daten und der Verwaltungsinformation nicht unterschieden werden, ob ein Block wirklich defekt ist oder nur als defekt erscheint.

Demnach kann eine Ursache für einen fehlerhaften Speicherinhalt nicht mit absoluter Sicherheit erkannt werden. Dennoch wird bei der Erkennung eines Speicherfehlers häufig entweder der entsprechende Block als defekt markiert und nicht wieder verwendet oder der Fehler ignoriert und der Block ganz normal weiter verwendet. Diese beiden Vorgehensweisen führen zu Problemen im Zusammenhang mit der Verfügbarkeit der Daten.

Falls defekt erscheinende Blöcke als defekt markiert und nicht wieder verwendet werden, werden diese zuverlässig nicht weiter verwendet, aber defekt erscheinende Blöcke, bspw. durch nicht abgeschlossene Schreibvorgänge, werden ebenfalls nicht wieder verwendet. Dies hat zu Folge, dass möglicherweise immer mehr defekt markierte, aber in Wirklichkeit intakte Blöcke im System vorliegen. Als Konsequenz werden die anderen Blöcke stärker durch Schreibzugriffe belastet oder es stehen nicht mehr hinreichend viele Blöcke zur Verfügung, so dass das System keine Daten mehr speichern kann. Eine Folge ist, dass das System als defekt erkannt wird, obwohl es nicht defekt ist.

Falls ein Fehler ignoriert und der Block ganz normal weiter verwendet wird, besteht nicht die Gefahr, intakte Blöcke als defekt zu erkennen und nicht wieder zu verwenden. Es besteht jedoch das Risiko, Blöcke mit permanenten Hardwarefehlern immer wieder zu verwenden und somit immer wieder Daten zu verlieren.

Aus der Druckschrift US 6 751 123 B2 ist eine Einrichtung bekannt, die dazu ausgebildet ist, die Ursache eines Fehlers von Daten, die aus einem Block eines nicht flüchtigen Halbleiterspeicher ausgelesen werden, zu bestimmen. Dies erfolgt auf der Grundlage einer aufgezeichneten Zählung von Fehlerkorrekturen. Weiterhin ist die Einrichtung dazu geeignet, fehlerhafte Daten innerhalb des Blocks zu erneuern oder ersatzweise abzuspeichern, falls sich herausstellt, dass ein Auftreten eines Fehler innerhalb des Blocks öfter stattfindet. Dabei ist ein erster, normaler Speicherbereich zur herkömmlichen Speicherung und somit Nutzung von Daten vorgesehen. Ein zweiter, zusätzlicher Speicherbereich weist eine Anzahl von Ersatz-Blöcken auf, wobei jeweils ein Ersatz-Block einem fehlerhaften Block des normalen Speicherbereichs zugeordnet wird, so dass dieser Block des zweiten, zusätzlichen Speicherbereichs ersatzweise Daten speichert, die in dem zugeordneten fehlerhaften Block des herkömmlichen; normalen Speicherbereichs gespeichert werden.

### Offenbarung der Erfindung

Bei dem erfindungsgemäßen Verfahren zum Betreiben einer Speichereinrichtung gemäβ Anspruch 1, Blöcke aufweist, werden Blöcke markiert, wobei als verdächtig markierte Blöcke beobachtet werden, wobei als vorübergehend fehlerbehaftet eingestufte Blöcke als verdächtig markiert und vorübergehend nicht verwendet werden, und wobei als fehlerfrei eingestufte Blöcke als intakt markiert und weiter verwendet werden, und wobei als dauerhaft fehlerbehaftet eingestufte Blöcke als defekt markiert und nicht verwendet werden. Ein als verdächtig markierter Block als wird intakt markiert und wieder verwendet, wenn eine Anzahl intakter Blöcke in der Speichereinrichtung eine bestimmte Grenze unterschreitet.

Vorteilhafte Ausführungsformen des Verfahrens ergeben sich aus den abhängigen Patentansprüchen.

Die Erfindung betrifft außerdem eine Vorrichtung zum Betreiben einer Speichereinrichtung gemäβ Anspruch 6, wobei diese Speichereinrichtung eine Anzahl Blöcke aufweist, und wobei die Vorrichtung dazu ausgebildet ist, Blöcke zu markieren, und als verdächtig markierte Blöcke zu beobachten, als vorübergehend fehlerbehaftet eingestufte Blöcke als verdächtig zu markieren und vorübergehend nicht zu verwenden, als fehlerfrei eingestufte Blöcke als intakt zu markieren und weiter zu verwenden, und als dauerhaft fehlerbehaftet eingestufte Blöcke als defekt zu markieren und nicht zu verwenden. Ein als verdächtig markierter Block wird als intakt markiert und wieder verwendet, wenn eine Anzahl intakter Blöcke in der Speichereinrichtung eine bestimmte Grenze unterschreitet.

Sämtliche Schritte des erfindungsgemäßen Verfahrens sind mit der erfindungsgemäßen Vorrichtung durchführbar. Zwischen der erfindungsgemäßen Vorrichtung und der Speichereinrichtung kann eine Wechselwirkung bestehen. In möglichen Ausführungsformen der Erfindung kann die Vorrichtung als eine Komponente der Speichereinrichtung oder die Speichereinrichtung als eine Komponente der Vorrichtung ausgebildet sein.

Das erfindungsgemäße Computerprogrammprodukt mit Pogrammcodemitteln, die auf einem computerlesbaren Datenträger gespeichert sind gemäβ Anspruch 8, ist dazu vorgesehen, alle Schritte eines erfindungsgemäßen Verfahrens durchzuführen, wenn das Computerprogramm auf einem Computer oder einer entsprechenden Recheneinheit, insbesondere einer erfindungsgemäßen Vorrichtung, ausgeführt wird.

Mit dem Verfahren oder einer entsprechenden Strategie kann eine Verfügbarkeit eines Dienstes zur Abspeicherung nichtflüchtiger Daten bei bestimmten blockorientierten EEPROM-Speichereinrichtungen oder -Dateisystemen erhöht werden.

Der jeweilige Block wird nicht nur als intakt, wobei der Block in diesem Fall entweder frei oder belegt sein kann, oder defekt erkannt oder klassifiziert und dementsprechend markiert. Da es nun möglich ist, den Block auch als verdächtig einzustufen, kann zudem ein zwischen intakt und defekt befindlicher Zwischenzustand des jeweiligen Blocks charakterisiert werden. Diesem neuen Zwischenzustand zugeordnete Blöcke können aufgrund einer derart bereitgestellten Markierung bei einer weiteren Entwicklung beobachtet werden.

Ein Block kann in Ausgestaltung nur nach Auftreten von zwei aufeinander folgenden Fehlern als defekt erkannt werden, wobei der zweite Fehler im Zustand verdächtig auftreten muss. Unter Ausnutzung dieser nunmehr drei Zustände intakt, verdächtig und defekt ist es möglich, die Wahrscheinlichkeiten zur richtigen Erkennung des realen Zustands eines Blocks zu erhöhen. Dabei können intakte Blöcke entweder frei oder belegt sein. Die Blöcke werden in einer Ausgestaltung aktiv als intakt oder verdächtig markiert. Eine aktive Markierung als defekt kann ebenfalls erfolgen, eine derartige Markierung kann aber auch automatisch durch den Defekt erfolgen.

Ein Vorteil der Erfindung liegt im Erreichen einer besseren Verfügbarkeit und längeren Lebensdauer der Speichereinrichtung. Zudem kann ein Abspeichern nichtflüchtiger Daten auf diese Weise verbessert werden.

Bei den hier betrachteten Speichereinrichtungen oder Dateisystemen werden Daten je nach Länge in einem Block oder mehreren Blöcken auf der jeweiligen Speichereinrichtung oder einem entsprechenden Medium gespeichert. Eine Erkennung von echten oder vermeintlichen physikalischen Fehlern in den Blöcken wird über ebenfalls auf dem Medium abgelegte Prüfdaten, bspw. CRC (Cyclic Redundancy Check) bei einem Prüfsummenverfahren, oder einen fehlererkennenden Code realisiert.

Es kann unterschiedliche Ursachen dafür geben, dass ein Block bzw. eine Speicherzelle fehlerhaft erscheint. So können in der Speicher-Hardware permanente Fehler, sog. stuck-at-Fehler,auftreten. Hierbei besitzt eine Speicherzelle immer nur einen Wert, in der Regel "logisch 0" oder "logisch 1". Dies sind permanente physikalische Fehler. Dieser Fehlertyp kann durch Korrekturlesen nach einer Speicherung entdeckt werden.

Des weiteren ist ein Auftreten von transienten Fehlern in der Hardware möglich, diese werden typischerweise durch EMV-Probleme oder kosmische Strahlung verursacht. Diese Fehler äußern sich in Bitkippern. Nach einem Überschreiben der entsprechenden Speicherzelle ist der Fehler nicht mehr vorhanden und wird auch an dieser Speicherzelle nicht mit einer höheren Wahrscheinlichkeit als zuvor erneut auftreten. Hierbei handelt es sich um einmalige physikalische Fehler.

Außerdem können in der Hardware Fehler aufgrund von Alterungserscheinungen auftreten. Mit zunehmender Anzahl von Operationen können die Speicherzellen ermüden, dies äußert sich in einer immer kürzeren Datenhaltungszeit. Wenn diese sog. "Data Retention Time" zu klein wird, führt dies zu immer wieder auftretenden Fehlern, die aber im Vergleich zu den permanenten Fehlern nicht durch erneutes Lesen eines zuvor geschriebenen Werts erkannt werden können. Verglichen mit transienten Fehlern treten Fehler durch Alterungserscheinungen immer wieder an den gleichen Speicherzellen auf.

Nicht abgeschlossene Schreibvorgänge durch Spannungsunterbrechungen oder Resets können Blöcke fehlerhaft erscheinen lassen, obwohl kein Hardwarefehler vorliegt. Es können in der Speichereinrichtung die gleichen Situationen wie durch Hardwarefehler entstehen.

Demnach können unterschiedliche Ursachen in den Blöcken zu identischen beobachtbaren Symptomen führen. Aus dem jeweiligen Symptom, insbesondere einem fehlerhaft erscheinenden Speicherinhalt des Blocks, ist die Ursache nicht eindeutig ersichtlich. Somit kann eine daraus zu ziehende Konsequenz, wonach der Block gemäß bekannter Vorgehensweisen weiterhin verwendet oder eben nicht mehr verwendet wird, nicht eindeutig festgelegt werden.

Mit dem neuen im Rahmen der vorliegenden Erfindung eingeführten Zustand "verdächtig" ist es möglich, einen als intakt markierten Block, bei dem einmal ein Fehler augetreten ist, zunächst nicht mehr zu verwenden. Damit wird das Risiko des Datenverlustes durch permanente Hardwaredefekte reduziert. Wenn die Anzahl der noch zur Verfügung stehenden Blöcke eine festzulegende Grenze unterschreitet, können auch die verdächtigen Blöcke wieder verwendet werden. Dies gilt in der Regel jedoch nur für Blöcke, die nach der Markierung als verdächtig nicht erneut verändert worden sind. Werden sie erneut und somit wiederholt verändert, gelten sie als defekt und werden nicht wieder verwendet.

Dabei ist zu beachten, dass ein freier Block sowohl die richtigen Werte für freie Blöcke als auch fehlerhafte Werte enthalten kann. Dies ist dann ersichtlich, wenn freie Blöcke komplett gelöscht und dabei mit bestimmten Werten gefüllt werden. Auch ein belegter Block kann korrekt oder fehlerhaft sein. Dies ist durch Prüfdaten oder einen fehlererkennenden Code ersichtlich. Es liegt somit an durchzuführenden Operationen der Speichereinrichtung oder des Dateisystems, mit Hilfe des zusätzlichen Zustands verdächtig eine Wahrscheinlichkeit für eine korrekte Zustandserkennung der Blöcke zu verbessern.

Bei einer Auswahl von Strategien zur Behandlung von fehlerhaft erscheinenden Blöcken haben verschiedene Aspekte Einfluss. So kann ein Fehlermodell der Speichereinrichtung und somit der Hardware berücksichtigt werden, dieses Fehlermodell kann Typen von Fehlern und Wahrscheinlichkeiten einzelner Typen von Fehlern umfassen.

Die möglichen Zustände für Blöcke können geeignet verwendet werden. Diesbezüglich ist es denkbar, Zeitpunkte einer Erkennung und Markierung verdächtiger Blöcke sowie eine Strategie zur Wiederverwendung verdächtiger Blöcke zu berücksichtigen.

In weiterer Ausgestaltung kann die Behandlung von Fehlern in einem Zusammenhang bzw. Kontext einer Verwaltung nichtflüchtiger Daten innerhalb der Speichereinrichtung oder des Dateisystems erfolgen. Außerdem kann die Behandlung von Fehlern von möglichen Einsatzbedingungen der Speichereinrichtung zur Verwaltung nichtflüchtiger Daten abhängig sein.

Das erfindungsgemäße Verfahren, mit dem eine Handhabung der unterschiedlichen Zustände der Blöcke möglich ist, kann anhand nicht-funktionaler Anforderungen erstellt werden.

Bestehen bspw. hohe Anforderungen an eine Langlebigkeit einer Speichereinrichtung, so sind unter diesem Aspekt gelegentliche Datenverluste akzeptabel. In diesem Fall können durch das Verfahren und eine Codierung der Daten auf der Speichereinrichtung bestimmte Richtlinien eingehalten werden.

Sofern ein Block einen Fehler enthält, der mit großer Wahrscheinlichkeit durch eine unterbrochene Operation mit anschließendem Neustart eines die Vorrichtung und/oder die Speichereinrichtung aufweisenden Dateisystems entstanden ist, kann dieser Block ganz normal weiter verwendet werden.

Falls ein Block einen Fehler enthält, der mit großer Wahrscheinlichkeit durch einen permanenten physikalischen Fehler entstanden ist, kann dieser Block als verdächtig markiert werden. Blöcke, die eine gewisse oder bestimmte, je nach Anforderung geeignet festlegbare Zeit lang verdächtig waren, in denen aber kein zweiter Fehler aufgetreten ist, können wieder in den Zustand intakt überführt werden.

Mit dem Verfahren kann sichergestellt werden, dass mit einer sehr großen Wahrscheinlichkeit nur wirklich defekte Blöcke als defekt klassifiziert und markiert werden. Die Qualität eines Dienstes zur Verwaltung von nichtflüchtigen Daten in den Blöcken der Speichereinrichtung kann verbessert werden, wobei qualitative Aussagen zur Güte gemacht werden können.

Das vorliegende, bspw. zweistufig durchführbare, Verfahren zur Behandlung möglicherweise defekter Blöcke bietet bei einem Projekt die Möglichkeit, eine Strategie zur Behandlung möglicherweise defekter Blöcke zu erstellen, die eine angemessene Kombination der nicht-funktionalen Anforderungen an Langlebigkeit und Datensicherheit berücksichtigt. Dies ist mit der bekannten Vorgehensweise, nach der ein Block entweder immer oder nie als defekt markiert wird, nicht möglich.

Aus einer adäquaten Nutzung der mit der Erfindung vorgestellten drei Zustände, intakt, verdächtig und defekt, kann die Wahrscheinlichkeit verringert werden, dass Blöcke mit permanenten Defekten, wie es beim Stand der Technik der Fall ist, immer wieder verwendet werden und dabei immer wieder Datenverluste verursachen. Außerdem wird vermieden, dass Blöcke mit vorübergehenden Fehlern nicht mehr verwendet werden. Dies führte dazu, dass die Speichereinrichtung früher als notwendig defekt erscheint.

Die Erfindung kann in einem eingebetteten System mit einem EEPROM-Dateisystem als Vorrichtung und/oder Speichereinrichtung eingesetzt werden.

Das Verfahren kann von bestimmten Speichereinrichtungen mit Dateisystemen auf Probleme mit redundanter Hardware verallgemeinert werden. Hierbei sind die Blöcke redundant, da mehr Blöcke zur Verfügung stehen als eigentlich benötigt werden und auf einige dieser Blöcke verzichtet werden kann. Es ist darüber hinaus in anderen Bereichen als nur in eingebetteten Systemen oder entsprechenden rechnergestützten Modulen anwendbar.

Das Verfahren zur Erkennung und Markierung verdächtiger Blöcke und deren Wiederverwendung kann im Detail durch weitere hier nicht erwähnte Aspekte beeinflusst werden.

Es kann verschiedene Aspekte geben, unter deren Berücksichtigung eine Wiederbelebung von als verdächtig markierten Blöcken erfolgen kann. Eine derartige Wiederbelebung kann bei Bedarf oder nach einer gewissen Zeit erfolgen. Es kann nur die benötigte Anzahl von Blöcken oder alle verdächtigen aber nicht defekten Blöcke wiederbelebt werden. Dies kann jeweils von nicht-funktionalen Anforderungen an das System abhängen.

Ein freier Block kann sowohl korrekte als auch fehlerhafte Werte enthalten. Durch Ausnutzen einer Hardwareeigenschaft bestimmter EEPROMs, wonach eine Lösch- und Schreiboperation ohne Einfluss auf die Lebensdauer des EEPROMs getrennt werden kann, kann das hier vorgestellte Konzept sinnvoll unterstützt werden.

Die Speichereinrichtung kann als EEPROM (Electrically Erasable Programmable Read-Only Memory), also als ein elektrisch löschbarer, programmierbarer Nur-Lese-Speicher, oder als ein nichtflüchtiger, elektronischer Speicherbaustein, der unter anderem in der Computertechnik auch in eingebetteten Systemen (Embedded Systems) eingesetzt wird, ausgebildet sein.

EEPROM-Speicher können mit der Erfindung durch effektive Nutzung vorhandener Blöcke sparsam verwendet werden. Dabei können bei Bedarf in angemessenem Rahmen andere Ressourcen wie RAM, ROM oder Laufzeit eingesetzt werden. Somit kann eine Verlängerung einer Lebensdauer von EEPROM-Speichern oder Speicher-Hardware erreicht werden.

Weitere Vorteile und Ausgestaltungen der Erfindung ergeben sich aus der Beschreibung und der beiliegenden Zeichnung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand von Ausführungsbeispielen in der Zeichnung schematisch dargestellt und wird im folgenden unter Bezugnahme auf die Zeichnung ausführlich beschrieben.

Kurze Beschreibung der Zeichnungen
- Figur 1: zeigt ein Diagramm für mögliche Übergänge von Zuständen von Blöcken.
- Figur 2: zeigt in schematischer Darstellung eine Ausführungsform einer Speichereinrichtung und einer Vorrichtung.

### Ausführungsformen der Erfindung

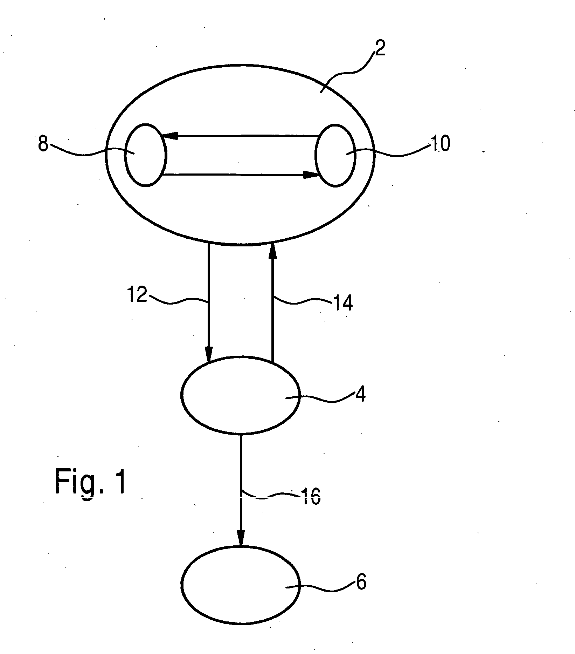

In dem Diagramm aus Figur 1 sind die drei möglichen Zustände intakt 2, verdächtig 4 und defekt 6, mit denen ein Block in einer Speichereinrichtung klassifiziert und markiert werden kann, dargestellt.

Bei dem Betrieb der Speichereinrichtung ist vorgesehen, dass der Block einem jeweils aktuellen Zustand entsprechend als intakt 2, verdächtig 4 oder defekt 6 markiert wird. Eine Defekt-Markierung kann aber auch durch Defekte des Systems entstehen.

Der Block wird als intakt 2 markiert, falls dieser keinen Fehler aufweist. Derartige fehlerfreie Blöcke werden bei Betrieb der Speichereinrichtung verwendet, dabei können diese als intakt 2 markierten Blöcke frei 8 oder mit Daten belegt 10 sein. Infolge sich immer wieder ergebender Lösch- und Schreibvorgänge ist jederzeit ein Wechsel des Blocks zwischen frei 8 und belegt 10 möglich.

Falls bei dem ursprünglich als intakt 2 markierten Block ein Fehler einer bestimmten Klasse auftritt, ist vorgesehen, dass dieser Block als verdächtig 4 markiert und somit einem Zwischenzustand zugeordnet wird, womit für den Block ein erster möglicher Übergang 12 zwischen den Zuständen intakt 2 und verdächtig 4 erfolgt. Ist der Block somit als verdächtig 4 markiert, wird dieser Block momentan nicht verwendet, des weiteren wird die weitere Entwicklung dieses Blocks beobachtet.

Falls sich der Zustand des als verdächtig 4 markierten Blocks nicht verändern sollte, was bedeutet, dass bei dem Block kein weiterer Fehler auftritt, wird der als verdächtig 4 markierte Block in einem zweiten möglichen Übergang 14 wieder als intakt 2 markiert und aus dem Zwischenzustand verdächtig 4 heraus reaktiviert. Dies kann nach einer festgelegten Zeitspanne oder in Abhängigkeit weiterer Bedingungen, falls dieser Block zur Speicherung von Daten wieder genutzt werden soll, erfolgen.

Für den Fall, dass in dem als verdächtig 4 markierten Block mindestens ein weiterer Fehler auftritt, gelangt dieser als verdächtig 4 markierte Block durch einen dritten möglichen Übergang 16 in den Zustand defekt 6. Dies bedeutet, dass dieser Block endgültig nicht mehr verwendet wird.

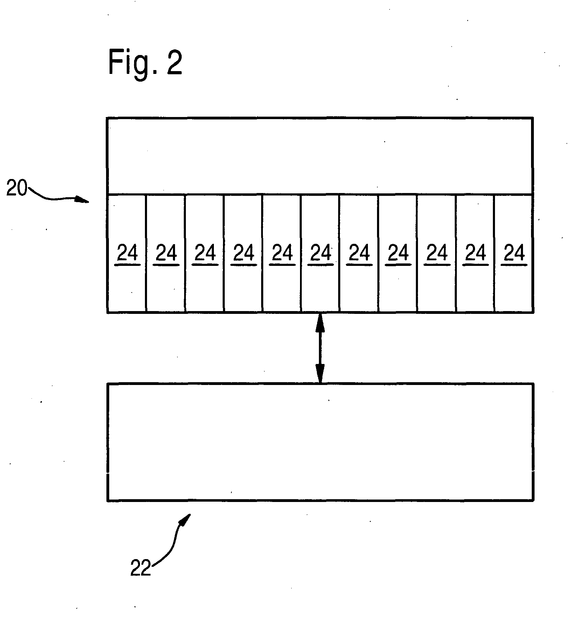

Figur 2 zeigt in schematischer Darstellung eine Ausführungsform einer Speichereinrichtung 20 sowie einer Vorrichtung 22, die miteinander in Wechselwirkung stehen. Dabei weist die Speichereinrichtung 22 eine Anzahl Blöcke 24 auf, in denen Daten gespeichert werden können. Derartige Daten können jedoch auch wieder gelöscht werden. Bei Durchführung des in Figur 1 beschriebenen Verfahrens wird bzw. ist jeder Block 24 entweder als intakt, verdächtig oder defekt markiert und einer jeweiligen Markierung entsprechend genutzt und behandelt. Eine derartige Klassifizierung und ein darauf beruhendes Markieren der Blöcke 24 der Speichereinrichtung 20 ist durch die Speichereinrichtung 20 und/oder die Vorrichtung 22 durchführbar.

## Patentansprüche

1. Verfahren zum Betreiben einer Speichereinrichtung (20), die Blöcke (24) aufweist, bei dem Blöcke (24) markiert werden,
wobei als vorübergehend fehlerbehaftet eingestufte Blöcke (24) als verdächtig (4) markiert und beobachtet werden, und wobei als fehlerfrei eingestufte Blöcke (24) als intakt (2) markiert und weiter verwendet werden, und wobei als dauerhaft fehlerbehaftet eingestufte Blöcke (24) als defekt (6) markiert und nicht verwendet werden, **dadurch gekennzeichnet, dass** als verdächtig (4) markierte Blöcke (24) vorübergehend nicht verwendet werden, jedoch als verdächtig (4) markierter Block (24) als intakt (2) markiert und wieder verwendet wird, wenn eine Anzahl intakter (2) Blöcke (24) in der Speichereinrichtung (20) eine bestimmte Grenze unterschreitet.

2. Verfahren nach Anspruch 1, bei dem bei einem Markieren eines Blocks (24) eine Häufigkeit von Fehlern, die in dem Block (24) auftreten, berücksichtigt wird.

3. Verfahren nach Anspruch 1, bei dem ein als intakt (2) markierter Block (24) nach einem Auftreten eines Fehlers einer Fehlerklasse als verdächtig (4) markiert wird.

4. Verfahren nach Anspruch 1 oder 3, bei dem ein als verdächtig (4) markierter Block (24) nach einem Auftreten eines Fehlers einer Fehlerklasse als defekt (6) markiert wird.

5. Verfahren nach einem der Ansprüche 1, 3 oder 4, bei dem für den Fall, dass sich ein als verdächtig (4) markierter Block (24) während einer festgelegten Zeitspanne nicht weiter verändert, dieser als verdächtig (4) markierte Block (24) als intakt (2) markiert und wieder verwendet wird.

6. Vorrichtung zum Betreiben einer Speichereinrichtung (20), wobei diese Speichereinrichtung (20) eine Anzahl Blöcke (24) aufweist, und wobei die Vorrichtung (22) dazu ausgebildet ist/Blöcke (24) zu markieren, und als vorübergehend fehlerbehaftet eingestufte Blöcke (24) als verdächtig (4) zu markieren und zu beobachten, als fehlerfrei eingestufte Blöcke (24) als intakt (2) zu markieren und weiter zu verwenden, und als dauerhaft fehlerbehaftet eingestufte Blöcke (24) als defekt (6) zu markieren und nicht zu verwenden,
**gekennzeichnet dadurch, dass**
als verdächtig (4) markierte Blöcke (24) vorübergehend nicht verwendet werden, jedoch ein als verdächtig (4) markierter Block (24) als intakt (2) markiert und wieder verwendet wird, wenn eine Anzahl intakter (2) Blöcke (24) in der Speichereinrichtung (20) eine bestimmte Grenze unterschreitet.

7. Vorrichtung nach Anspruch 6, die die Speichereinrichtung (20) aufweist.

8. Computerprogrammprodukt mit Programmcodemitteln, die auf einem computerlesbaren Datenträger gespeichert sind, um alle Schritte eines Verfahrens nach einem der Ansprüche 1 bis 5 durchzuführen, wenn das Computerprogramm auf einem Computer oder einer entsprechenden Recheneinheit, insbesondere einer Vorrichtung (22) nach Anspruch 6, ausgeführt wird.

## Claims

1. Method for operating a memory device (20) having blocks (24), wherein blocks (24) are marked, wherein blocks (24) classified as temporarily defective are marked as suspicious (4) and observed, and wherein blocks (24) classified as defect-free are marked as intact (2) and continue to be used, and wherein blocks (24) classified as permanently defective are marked as defective (6) and are not used, **characterized in that** blocks (24) marked as suspicious (4) are temporarily not used, but a block (24) marked as suspicious (4) is marked as intact and is used again if a number of intact (2) blocks (24) in the memory device (20) falls below a specific limit.

2. Method according to Claim 1, wherein, during a marking of a block (24), a frequency of defects that occur in the block (24) is taken into account.

3. Method according to Claim 1, wherein a block (24) marked as intact (2) is marked as suspicious (4) after occurrence of a defect of a defect class.

4. Method according to Claim 1 or 3, wherein a block (24) marked as suspicious (4) is marked as defective (6) after occurrence of a defect of a defect class.

5. Method according to any of Claims 1, 3 or 4, wherein, for the case where a block (24) marked as suspicious (4) does not change further during a defined time period, said block (24) marked as suspicious (4) is marked as intact (2) and is used again.

6. Apparatus for operating a memory device (20), wherein said memory device (20) has a number of blocks (24), and wherein the apparatus (22) is designed to perform processes such that blocks (24) are marked, and blocks (24) classified as temporarily defective are marked as suspicious (4) and observed, and blocks (24) classified as defect-free are marked as intact (2) and continue to be used, and blocks (24) classified as permanently defective are marked as defective (6) and are not used, **characterized in that** blocks (24) marked as suspicious (4) are temporarily not used, but a block (24) marked as suspicious (4) is marked as intact and is used again if a number of intact (2) blocks (24) in the memory device (20) falls below a specific limit.

7. Apparatus according to Claim 6, which comprises the memory device (20).

8. Computer program product comprising program code means which are stored on a computer-readable data carrier in order to carry out all the steps of a method according to any of Claims 1 to 5 if the computer program is executed on a computer or a corresponding computing unit, in particular an apparatus (22) according to Claim 6.

## Revendications

1. Procédé d'exploitation d'un dispositif de mémorisation (20) qui présente des blocs (24), selon lequel les blocs (24) sont marqués, les blocs (24) classifiés comme temporairement erronés étant marqués suspects (4) puis observés, et les blocs (24) classifiés comme exempts d'erreurs étant marqués intacts (2) et toujours utilisés, et les blocs (24) classifiés comme durablement erronés étant marqués défectueux (6) et non utilisés, **caractérisé en ce que** les blocs (24) marqués suspects (4) ne sont temporairement pas utilisés, mais un bloc (24) marqué suspect (4) est cependant marqué intact (2) et de nouveau utilisé lorsqu'un nombre de blocs (24) intacts (2) dans le dispositif de mémorisation (20) devient inférieur à une limite donnée.

2. Procédé selon la revendication 1, selon lequel une fréquence des erreurs qui se produisent dans un bloc (24) est prise en compte lors d'un marquage du bloc (24).

3. Procédé selon la revendication 1, selon lequel un bloc (24) marqué intact (2) est marqué suspect (4) après la survenance d'une erreur d'une classe d'erreur.

4. Procédé selon la revendication 1 ou 3, selon lequel un bloc (24) marqué suspect (4) est marqué défectueux (6) après la survenance d'une erreur d'une classe d'erreur.

5. Procédé selon l'une des revendications 1, 3 ou 4, selon lequel, dans le cas où un bloc (24) marqué suspect (4) ne change plus pendant un intervalle de temps donné, ce bloc (24) marqué suspect (4) est marqué intact (2) puis réutilisé.

6. Dispositif d'exploitation d'un dispositif de mémorisation (20), ce dispositif de mémorisation (20) présentant un certain nombre de blocs (24) et le dispositif (22) étant configuré pour marquer des blocs (24), et pour marquer suspects (4) puis observer les blocs (24) classifiés comme temporairement erronés, et pour marquer intacts (2) et toujours utiliser les blocs (24) classifiés comme exempts d'erreurs, et pour marquer défectueux (6) et ne pas utiliser les blocs (24) classifiés comme durablement erronés,
**caractérisé en ce que**
les blocs (24) marqués suspects (4) ne sont temporairement pas utilisés, mais un bloc (24) marqué suspect (4) est cependant marqué intact (2) et de nouveau utilisé lorsqu'un nombre de blocs (24) intacts (2) dans le dispositif de mémorisation (20) devient inférieur à une limite donnée.

7. Dispositif selon la revendication 6, qui présente le dispositif de mémorisation (20).

8. Produit de programme informatique comprenant des moyens de code de programme qui sont enregistrés sur un support de données lisible par ordinateur afin d'exécuter toutes les étapes d'un procédé selon l'une des revendications 1 à 5 lorsque le programme informatique est exécuté sur un ordinateur ou une unité de calcul correspondante, notamment un dispositif (22) selon la revendication 6.
